# EUROPEAN PATENT APPLICATION

(11) **EP 2 844 042 A1**
(43) Date of publication of application: **04.03.2015**
(21) Application number: 13867632.5
(22) Date of filing: 26.12.2013
(51) Int. Cl.: H05H 1/24

(54) **PLASMA REACTOR AND PLASMA IGNITION METHOD USING SAME**

(30) Priority: 28.12.2012 KR 20120156816
(71) Applicant: New Power Plasma Co., Ltd., Suwon-si, Gyeonggi-do 443-390 (KR)
(72) Inventor: Choi, Sang-Don, Gunpo-si Gyeonggi-do 435-720 (KR)
(74) Representative: Petraz, Gilberto Luigi
(86) International application number: PCT/KR2013/012200
(87) International publication number: WO 2014/104753

(57) **Abstract**

A plasma reactor and a plasma ignition method using the same are disclosed. The disclosed plasma reactor includes at least one magnetic core having a transformer primary winding wound thereon, an AC power supply for supplying AC power to the transformer primary winding wound on the magnetic core, at least one plasma chamber body, at which the magnetic core is installed, to directly induce a voltage in the plasma chamber body through the magnetic core, thereby inducing induced electromotive force in the plasma chamber body, and at least one floating chamber connected to the plasma chamber body via an insulating region, the induced electromotive force from the plasma chamber body being indirectly transferred to the floating chamber. Ignition of plasma is generated in accordance with a voltage difference generated between the plasma chamber body and the floating chamber, and the ignited plasma is supplied to a process chamber.

## Description

### BACKGROUND OF THE INVENTION

### Field of the Invention

The present invention relates to a plasma reactor and a plasma ignition method using the same, and more particularly to a plasma reactor capable of achieving plasma discharge even when a relatively low voltage is supplied in a transformer coupled plasma (TCP) or inductively coupled plasma (ICP) source system, as compared to conventional cases, and alleviating plasma discharge conditions while being advantageous in terms of maintenance or continuance of plasma after initiation of plasma discharge when the same voltage as that of conventional cases is supplied, as compared to conventional cases, and a plasma ignition method using the plasma reactor.

### Description of the Related Art

Plasma means a gas state in which electrons having negative charges and ions having positive charges are separated from each other at an ultrahigh temperature. In this state, the resultant gas, namely, plasma, exhibits neutrality because high charge separation is exhibited, and the number of negative charges and the number of positive charges are generally equal.

Generally, states of matter are divided into solid, liquid, and gas. Plasma is frequently referred to as the fourth state of matter. When energy is applied to a solid, the solid is changed into a liquid and then into a gas. When high energy is again applied to the gas, the gas is separated into electrons and atomic nuclei at a temperature of several ten thousand °C and, as such, has a plasma state.

Plasma discharge is utilized to generate gas excitation to produce an active gas containing ions, free radicals, atoms, or molecules. Such an active gas is widely used in various fields. Typically, active gases are used for various purposes, for example, etching, deposition, cleaning, and ashing.

Recently, wafers or LCD glass substrates for manufacture of semiconductor devices tend to be increased in size. To this end, an easily expandable plasma source exhibiting high control ability for plasma ion energy and treatment ability for a large area is required.

It has been known that a remote plasma source is very useful in a semiconductor manufacturing process using plasma. For example, remote plasma sources are effectively used in a cleaning process for a process chamber or an ashing process for photoresist strips.

As a remote plasma reactor (also, referred to as a "remote plasma generator"), there is a remote plasma reactor using a transformer coupled plasma source (TCPS) or a remote plasma reactor using an inductively coupled plasma source (ICPS). The remote plasma reactor using TCPS has a configuration in which a magnetic core with a primary winding coil is mounted to a reactor body having a toroidal structure.

Hereinafter, a conventional remote plasma reactor using TCPS will be described with reference to the accompanying drawings.

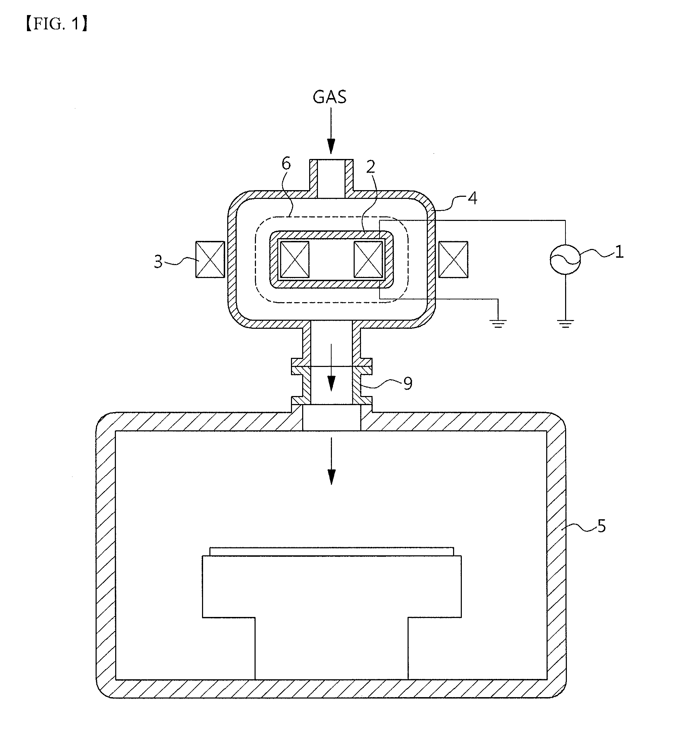

FIG. 1 is a view showing a configuration of a plasma treatment apparatus.

Referring to FIG. 1, the plasma treatment apparatus includes a remote plasma reactor and a process chamber 5. The remote plasma reactor includes a plasma chamber 4 having a toroidal shape, a magnetic core 3 installed at the plasma chamber 4, and an AC power supply 1 to supply AC power to a primary winding 2 wound on the magnetic core 3. The primary winding 2 and magnetic core 3 constitute a transformer. When the remote plasma reactor operates, a gas is introduced into the plasma chamber 4, and AC power supplied from the AC power supply 1 is supplied to the primary winding 2 of the transformer, to drive the primary winding 2. When the primary winding 2 is driven, induced electromotive force is transferred to the interior of the plasma chamber 4 and, as such, a reactor discharge loop 6 for plasma discharge is induced in the plasma chamber 4. Thus, plasma is generated. The plasma chamber 4 is connected to the process chamber 5 via an adapter 9 and, as such, the plasma generated in the plasma chamber 4 is supplied to the process chamber 5, to treat a substrate to be processed in the process chamber 5.

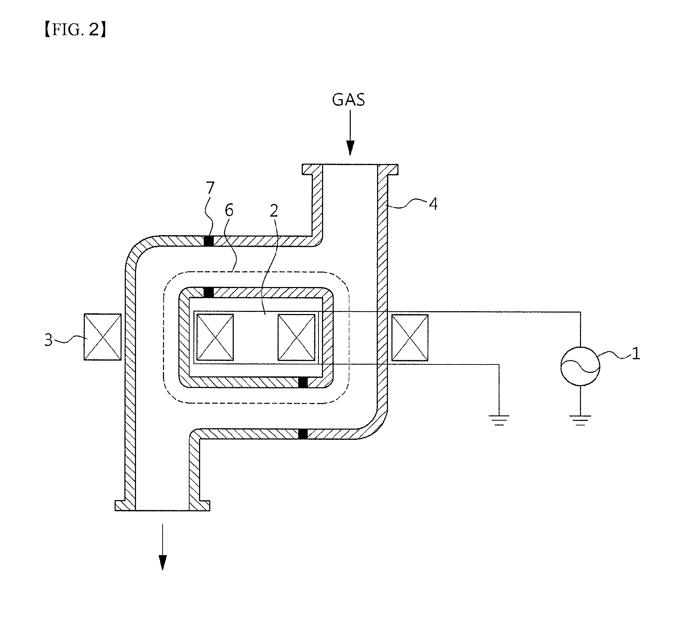

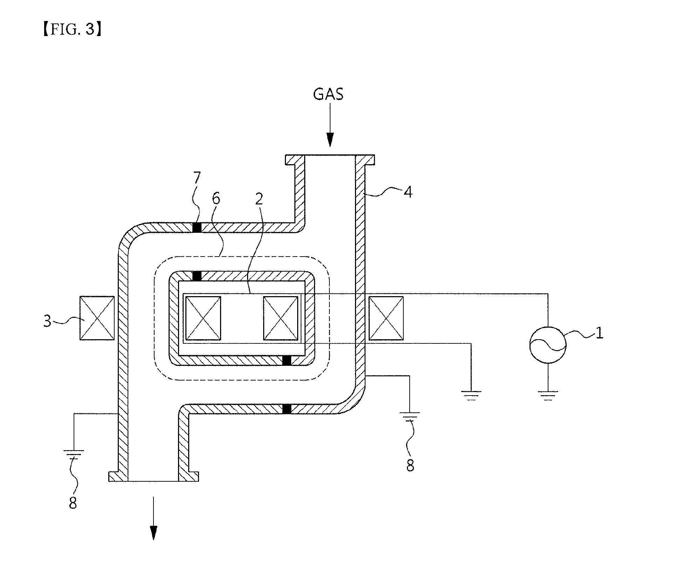

FIGS. 2 and 3 are views showing another conventional remote plasma generator.

Referring to FIGS. 2 and 3, when the remote plasma generator operates, AC power from the AC power supply 1 is supplied to the primary winding 2 wound on the magnetic core 3. In this case, gas present in the plasma chamber 4 is changed into a plasma state through plasma discharge carried out by the reactor discharge loop 6 formed in the plasma chamber 4. The plasma chamber 4 may be connected to a ground 8. Since the plasma chamber 4 has an annular structure, AC current in the plasma chamber 4 may be completely consumed. In order to prevent such a phenomenon, an insulator 7 is provided. The insulator 7 is made of a dielectric material such as ceramic. The AC power supply 1 supplies AC power having a phase inverting in accordance with a predetermined frequency (Hz).

In such a conventional remote plasma reactor, ignition of plasma is achieved through application of high-voltage AC power. However, when a high voltage of, for example, 500V, is applied to the interior of the plasma chamber 4 maintained at a low atmospheric pressure of, for example, 8 torr, ignition failure may occur at a rate of 2 to 3 times per 1,000 times. When ignition failure occurs, it is necessary to perform a task for re-ignition and, as such, process time is increased. Furthermore, costs are increased due to re-ignition. The interior of the plasma chamber 4 may also be damaged due to arc discharge. In addition, the insulator 7 of the plasma reactor may be easily damaged or broken due to plasma generated in the plasma chamber 4. In this case, no plasma may be generated.

### SUMMARY OF THE INVENTION

Therefore, the present invention has been made in view of the above problems, and it is an object of the present invention to provide a plasma reactor capable of achieving plasma discharge even when a relatively low voltage is supplied in a transformer coupled plasma (TCP) or inductively coupled plasma (ICP) source system, as compared to conventional cases, and a plasma ignition method using the plasma reactor.

It is another object of the present invention to provide a plasma reactor capable of easily achieving plasma discharge and easily maintaining the generated plasma, as compared to conventional cases, even when the same voltage as that of conventional cases is supplied, and a plasma ignition method using the plasma reactor.

It is another object of the present invention to provide a plasma reactor capable of achieving plasma discharge even when a relatively low voltage is supplied, as compared to conventional cases, thereby enabling supply of an inexpensive product while minimizing damage to the plasma reactor caused by arc discharge, and a plasma ignition method using the plasma reactor.

It is another object of the present invention to provide a plasma reactor capable of easily achieving ignition for plasma discharge, as compared to conventional cases, even when the same voltage as that of conventional cases is supplied at a low gas flow rate and a low gas pressure, and a plasma ignition method using the plasma reactor.

It is a further object of the present invention to provide a plasma reactor capable of easily achieving ignition for plasma discharge, as compared to conventional cases, even when the same voltage as that of conventional cases is supplied at a low temperature, and a plasma ignition method using the plasma reactor.

In accordance with an aspect of the present invention, the above and other objects can be accomplished by the provision of a plasma reactor including at least one magnetic core having a transformer primary winding wound thereon, an AC power supply for supplying AC power to the transformer primary winding wound on the magnetic core, at least one plasma chamber body, at which the magnetic core is installed, to directly induce a voltage in the plasma chamber body through the magnetic core, thereby inducing induced electromotive force in the plasma chamber body, and at least one floating chamber connected to the plasma chamber body via an insulating region, the induced electromotive force from the plasma chamber body being indirectly transferred to the floating chamber, wherein ignition of plasma is generated in accordance with a voltage difference generated between the plasma chamber body and the floating chamber, and the ignited plasma is supplied to a process chamber.

The plasma chamber body and the floating chamber may have a linear shape, to establish a discharge path therein.

The at least one magnetic core may include a plurality of magnetic cores, and the at least one plasma chamber body may include a plurality of plasma chamber bodies, at which the plural magnetic cores are installed, respectively.

The plasma chamber body and the floating chamber may have a loop shape, to establish a loop-shaped discharge path therein.

The at least one magnetic core may include at least four magnetic cores, and the at least one plasma chamber body may include a plurality of plasma chamber bodies, at which the magnetic cores are installed such that at least one of the magnetic cores is installed at each of the plasma chamber bodies, to form a symmetrical structure in the loop-shaped discharge path.

The plasma chamber body and the floating chamber may be made of the same material.

The material may be aluminum.

The material may be one of a conductor material and a dielectric material.

The dielectric material may be ceramic.

The plasma chamber body and the floating chamber may be made of a dielectric material. A conductor layer may be formed on a peripheral surface of the plasma chamber body or a peripheral surface of the floating chamber.

The insulating region may be made of a dielectric material, and may include a rubber for vacuum insulation.

The dielectric material may be ceramic.

The insulating region may have a width determined in accordance with an intensity of a voltage of the AC power supplied from the AC power supply.

The floating chamber may include a resistor for discharging charges charged after a plasma process to supply the plasma to the process chamber, and a switching circuit for connecting the resistor and the floating chamber after the plasma process.

In accordance with another aspect of the present invention, there is provided a plasma reactor including at least one magnetic core having a transformer primary winding wound thereon, an AC power supply for supplying AC power to the transformer primary winding wound on the magnetic core, at least one plasma chamber body, at which the magnetic core is installed, to directly induce a voltage in the plasma chamber body through the magnetic core, thereby inducing induced electromotive force in the plasma chamber body, and a plurality of floating chambers connected to the plasma chamber body via insulating regions, the induced electromotive force from the plasma chamber body being indirectly transferred to the floating chambers, wherein the plural floating chambers are connected to one another by insulating regions, and ignition of plasma is generated in accordance with a voltage difference generated between the plasma chamber body and the floating chambers, and the ignited plasma is supplied to a process chamber.

The plasma chamber body and the floating chambers may have a linear shape, to establish a discharge path therein.

The at least one magnetic core may include a plurality of magnetic cores, and the at least one plasma chamber body may include a plurality of plasma chamber bodies, at which the plural magnetic cores are installed, respectively.

The plasma chamber body and the floating chambers may have a loop shape, to establish a loop-shaped discharge path therein.

The at least one magnetic core may include at least four magnetic cores, and the at least one plasma chamber body may include a plurality of plasma chamber bodies, at which the magnetic cores are installed such that at least one of the magnetic cores is installed at each of the plasma chamber bodies, to form a symmetrical structure in the loop-shaped discharge path.

The plasma chamber body and the floating chambers may be made of the same material.

The material may be aluminum.

The material may be one of a conductor material and a dielectric material.

The dielectric material may be ceramic.

The plasma chamber body and the floating chambers may be made of a dielectric material, and a conductor layer may be formed on a peripheral surface of the plasma chamber body or peripheral surfaces of the floating chambers.

The insulating region may be made of a dielectric material, and may include a rubber for vacuum insulation.

The dielectric material may be ceramic.

The insulating region may have a width determined in accordance with an intensity of a voltage of the AC power supplied from the AC power supply.

Each of the floating chambers may include a resistor for discharging charges charged after a plasma process to supply the plasma to the process chamber, and a switching circuit for connecting the resistor and the floating chamber after the plasma process.

Additional insulating regions may be formed at a gas inlet and a gas outlet, respectively.

Each of the additional insulating regions is formed at a position crossing the plasma chamber body, at which the magnetic core is installed.

An additional insulating region may be formed at a gas inlet.

An additional insulating region may be formed at a gas outlet.

One of the plural floating chambers may be connected to a ground.

One of the floating chambers, which is provided with a gas inlet, may be in a floated state, and another one of the floating chambers, which is provided with a gas outlet, may be connected to the ground.

In accordance with another aspect of the present invention, there is provided a plasma ignition method including supplying a gas through a gas inlet while supplying AC power from a AC power supply to a primary winding wound on a magnetic core, directly inducing induced electromotive force in a plasma chamber body, at which the magnetic core is installed, transferring the induced electromotive force induced in the plasma chamber body to a plurality of floating chambers, thereby inducing discharge of plasma in a reactor body, supplying the discharged plasma to a process chamber through a gas outlet, and connecting each of the floating chambers to a high resistor, for discharge of charges charged in the floating chamber after the induction of plasma discharge.

The connecting the floating chamber to the high resistor may include connecting the floating chamber to the high resistor via a switching circuit.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a view explaining a conventional transformer coupled plasma (TCP)/inductively coupled plasma (ICP) coupled plasma reactor;
FIGS. 2 and 3 are views explaining another conventional TCP/ICP coupled plasma reactor;
FIG. 4 is a view illustrating a TCP/ICP plasma reactor according to a first embodiment of the present invention;
FIG. 5 is a view explaining a TCP/ICP coupled plasma reactor according to a second embodiment of the present invention;
FIG. 6 is a view explaining a TCP/ICP coupled plasma reactor according to a third embodiment of the present invention;
FIG. 7 is a view explaining a TCP/ICP coupled plasma reactor according to a fourth embodiment of the present invention;
FIG. 8 is a view explaining a TCP/ICP coupled plasma reactor according to a fifth embodiment of the present invention;
FIG. 9 is a view explaining a TCP/ICP coupled plasma reactor according to a sixth embodiment of the present invention;
FIG. 10 is a view explaining a TCP/ICP coupled plasma reactor according to a seventh embodiment of the present invention;
FIG. 11 is a view explaining a TCP/ICP coupled plasma reactor according to an eighth embodiment of the present invention;
FIG. 12 is a view explaining a TCP/ICP coupled plasma reactor according to a ninth embodiment of the present invention;
FIG. 13 is a view explaining a TCP/ICP coupled plasma reactor according to a tenth embodiment of the present invention;
FIG. 14 is a view explaining a TCP/ICP coupled plasma reactor according to an eleventh embodiment of the present invention;
FIG. 15 is a view explaining a TCP/ICP coupled plasma reactor according to a twelfth embodiment of the present invention;
FIG. 16 is a view explaining a TCP/ICP coupled plasma reactor according to a thirteenth embodiment of the present invention;
FIG. 17 is a view explaining a TCP/ICP coupled plasma reactor according to a fourteenth embodiment of the present invention;
FIG. 18 is a view explaining a TCP/ICP coupled plasma reactor according to a fifteenth embodiment of the present invention;
FIG. 19 is a view explaining a TCP/ICP coupled plasma reactor according to a sixteenth embodiment of the present invention;
FIG. 20 is a view explaining a TCP/ICP coupled plasma reactor according to a seventeenth embodiment of the present invention; and
FIG. 21 is a view explaining a TCP/ICP coupled plasma reactor according to an eighteenth embodiment of the present invention.

### DETAILED DESCRIPTION OF THE INVENTION

Hereinafter, embodiments will be described in detail with reference to the annexed drawings for better understanding. However, it will be apparent that the embodiments may be modified in various ways and the scope of the embodiments should not be construed as being limited to the following description. Thus, the embodiments are provided to ensure more perfect comprehension of the embodiments by one of ordinary skill in the art. For clarity, shapes, etc. of respective constituent members illustrated in the drawings may be exaggerated. Wherever possible, the same reference numbers will be used throughout the drawings to refer to the same or like parts. In the following description of the present invention, a detailed description of known functions and configurations incorporated herein will be omitted when it may obscure the subject matter of the present invention.

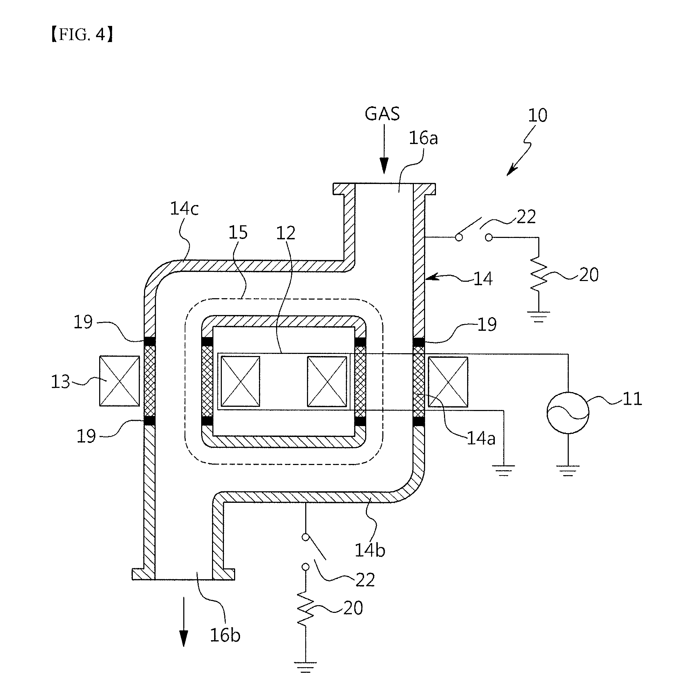

FIG. 4 is a view illustrating a transformer coupled plasma (TCP)/inductively coupled plasma (ICP) plasma reactor according to a first embodiment of the present invention.

Referring to FIG. 4, the plasma reactor, which is designated by reference numeral "10", includes a plasma chamber body 14a, first and second floating chambers 14b and 14c, a magnetic core 13, and an AC power supply 11. In the embodiment of the present invention, the plasma reactor 10 is a TCP type remote plasma generator.

The plasma reactor 10 has a discharge space for plasma discharge defined therein. The plasma reactor 10 includes a gas inlet 16a and a gas outlet 16b. The gas inlet 16a is connected to a gas supply source to supply a process gas for plasma discharge. The process gas supplied from the gas supply source is introduced into the reactor body 14 through the gas inlet 16b. The gas outlet 16b is connected to a process chamber (not shown). Plasma generated in the plasma reactor 10 is supplied to the process chamber (not shown) through the gas outlet 16b.

A loop-shaped discharge path is established in the plasma reactor 10. The plasma reactor 10 includes a plasma chamber body 14a, first and second floating chambers 14b and 14c, and insulating regions 19. The magnetic core 13 is installed at the plasma chamber body 14a and, as such, induced electromotive force is induced in the plasma chamber body 14a as a voltage is directly induced in the magnetic core 13. The first and second floating chambers 14b and 14c are connected via the insulating regions 19 at opposite sides of the plasma chamber body 14a. The first and second floating chambers 14b and 14c are floated for indirect transfer of the induced electromotive force induced from the plasma chamber body 14a. Each insulating region 19 is provided between the plasma chamber body 14a and a corresponding one of the floating chambers 14b and 14c, to insulate the plasma chamber body 14a and floating chambers 14b and 14c. The width of each insulating region 19 may be adjusted in accordance with the intensity of the voltage of AC power supplied from the AC power supply 11. When the voltage of the AC power is high, it may be possible to adjust the width of each insulating region 19, as compared to the case in which the voltage of the AC power is low. In other words, it may be possible to adjust the spacing between the plasma chamber body 14a and each of the floating chambers 14a and 14b, using the insulating regions 9. For example, when the voltage of the AC power supplied from the AC power supply 11 is high, the insulating regions 19 are formed such that the spacing between the plasma chamber body 14a and each of the floating chambers 14a and 14b is increased, as compared to the case in which the voltage of the AC power is low.

The plasma chamber body 14a and first and second floating chambers 14a and 14b may be made of a conductor material such as aluminum or a dielectric material such as ceramic. When the plasma chamber body 14a and first and second floating chambers 14a and 14b are made of a conductor material such as aluminum, the insulating regions 19 may be made of a dielectric material. In particular, the insulating regions 19 may be made of ceramic, which is a dielectric material. The insulating regions 19 may include rubber for vacuum insulation of the plasma reactor 10. When the plasma chamber body 14a and first and second floating chambers 14a and 14b are made of a dielectric material, a conductor layer may be formed over outer peripheral surfaces of the plasma chamber body 14a and first and second floating chambers 14a and 14b. The plasma reactor 10 may be formed to have a toroidal shape or a linear shape.

The magnetic core 13 is made of a ferrite material, and is installed at the plasma chamber body 14a of the plasma reactor 10. The primary winding 12 of the transformer is wound on the magnetic core 13. The AC power supply 11 supplies AC power to the primary winding 12 wound on the magnetic core 13. The AC power supply 11 supplies, to the primary winding 12, AC power having a phase inverting in accordance with a predetermined frequency (Hz). The AC power supply 11 may include an adjustment circuit for impedance matching. Alternatively, the AC power supply 11 may supply power to the primary winding 12 via a separate impedance matching circuit. When a plurality of magnetic cores 13 is installed, primary windings 12 are wound on respective magnetic cores 13 and, as such, the magnetic cores 13 receive AC power from different AC power supplies 11, respectively. Alternatively, a single primary winding 12 may be wound on the magnetic cores 13 and, as such, the magnetic cores 13 receive AC power from a single AC power supply 11.

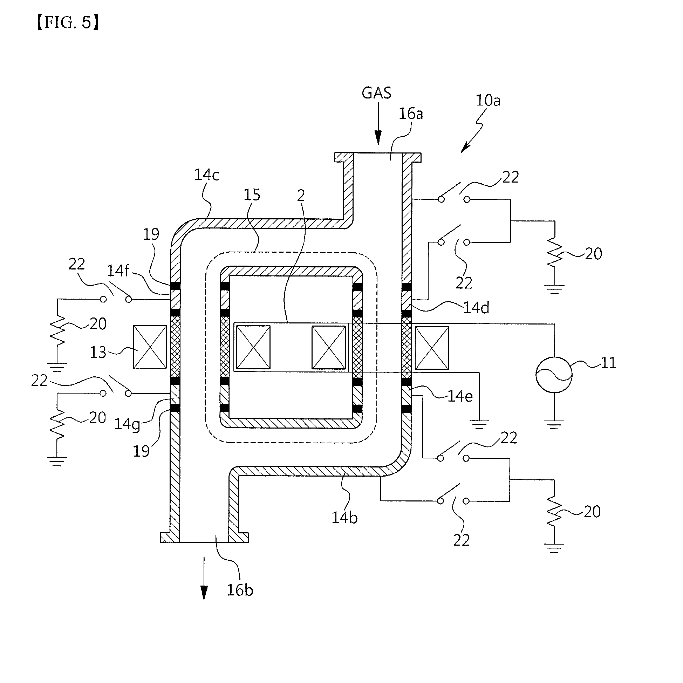

When a gas is introduced into the gas inlet 16a of the plasma reactor 10, and the primary winding 12 is driven in accordance with supply of AC power from the AC power supply 11, plasma is generated in the plasma discharge space by a reactor discharge loop 15 induced in the plasma reactor 10. The plasma generated in the plasma reactor 10 is supplied to a process chamber (not shown) for treatment of substrates. In this case, induced electromotive force is directly induced in the plasma chamber body 14a, at which the magnetic core 13 is installed. The induced electromotive force directly induced from the plasma chamber body 14a is transferred to the first and second floating chambers 14b and 14c via the insulating regions 19 because the first and second floating chambers 14b and 14c are insulated from the plasma chamber body 14a by the insulating regions 19. When AC power is supplied to the primary winding 12, the plasma chamber body 14a is charged, at one side thereof, with positive (+) charges, while being charged, at the other side thereof, with negative (-) charges. This charging phenomenon occurs in an alternating manner in accordance with the frequency of the AC power. In this case, the first and second floating chambers 14b and 14c tend to maintain the previously charged positive (+) or negative (-) state without immediately reacting to the voltage induced in the plasma chamber body 14a, by virtue of the insulating regions 19, as illustrated in FIG. 5.

In this case, a voltage difference is generated between the plasma chamber body 14a and each of the first and second floating chambers 14b and 14c because the AC power supply 11 supplies AC power having a phase inverting in accordance with a predetermined frequency. Accordingly, it is possible to achieve plasma discharge even at a low voltage by maximizing the voltage difference generated between the plasma chamber body 14a and each of the first and second floating chambers 14b and 14c.

For example, when a high voltage of 500V is applied to the plasma chamber body 14a, the first and second floating chambers 14b and 14c, which are independent of each other, have opposite phases. Accordingly, when the supply voltage is reduced by 1/2, the same or similar effects are obtained upon plasma ignition. In this case, it is possible to reduce a damage that may be generated at the plasma chamber body 14a or first or second floating chamber 14b or 14c due to arc discharge. On the other hand, when the supply voltage is maintained at 500V, the same effects as those of the case in which a voltage of about 950V is applied are exhibited. In this case, there is an effect that plasma discharge is more smoothly generated at a rate that is about 2 times that of the above case.

Each of the first and second floating chambers 14b and 14c may be completely or partially floated. Each of the first and second floating chambers 14b and 14c may be connected to a high resistor 20 by a switching circuit 22. When the primary winding 12 wound on the magnetic core 13 is driven by AC power supplied from the AC power supply 11, induced electromotive force is directly induced in the plasma chamber body 14a, at which the magnetic core 13 is installed. The induced electromotive force induced in the plasma chamber body 14a is transferred to the first and second plasma chambers 14b and 14c and, as such, plasma discharge is generated in the plasma reactor 10. The generated plasma is supplied to the process chamber. In this case, each of the first and second floating chambers 14b and 14c is connected to the high resistor 20 via the switching circuit 22, in order to discharge charges charged in the first and second floating chambers 14b and 14c after supply of plasma, that is, the plasma process. The floating chambers included in all embodiments of the present invention may be connected to the high resistor 20 via the switching circuit 22 and, as such, no detailed description thereof will be given in conjunction with the embodiments, which will be described hereinafter.

FIG. 5 is a view explaining a TCP/ICP coupled plasma reactor according to a second embodiment of the present invention.

Referring to FIG. 5, the plasma reactor, which is designated by reference numeral "10a", includes a plasma chamber body 14a, at which a magnetic core 13 is installed, and a plurality of floating chambers 14b, 14c, 14d, 14e, 14f, and 14g. Each of the plural floating chambers 14b, 14c, 14d, 14e, 14f, and 14g is insulated from the plasma chamber body 14a and the remaining floating chambers. A voltage directly induced in the plasma chamber body 14a through the magnetic core 13 is indirectly transferred to third, fourth, fifth, and sixth ones of the floating chambers, namely, the floating chambers 14d, 14e, 14f, and 14g. The transferred voltage is then transferred to first and second ones of the floating chambers, namely, the floating chambers 14a and 14b. Each of the first to sixth floating chambers 14b to 14g are connected to a high resistor 20 by a switching circuit 22.

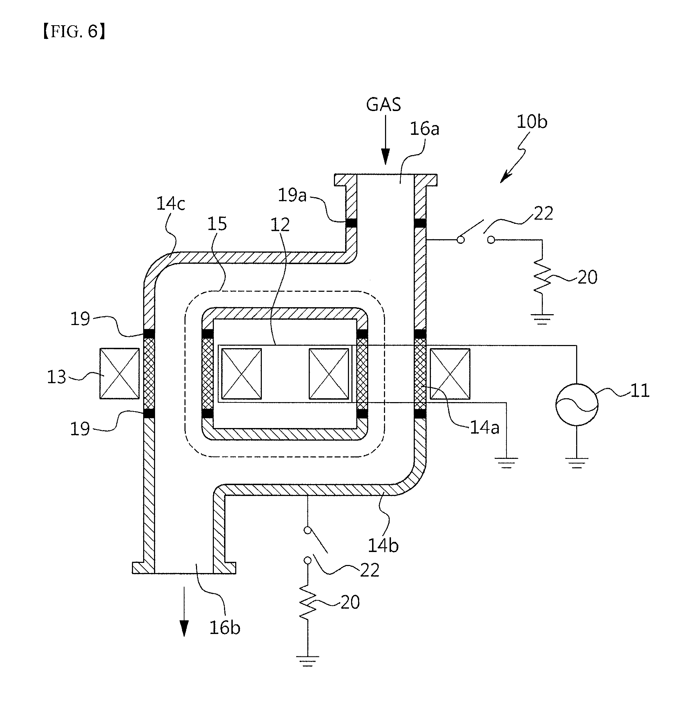

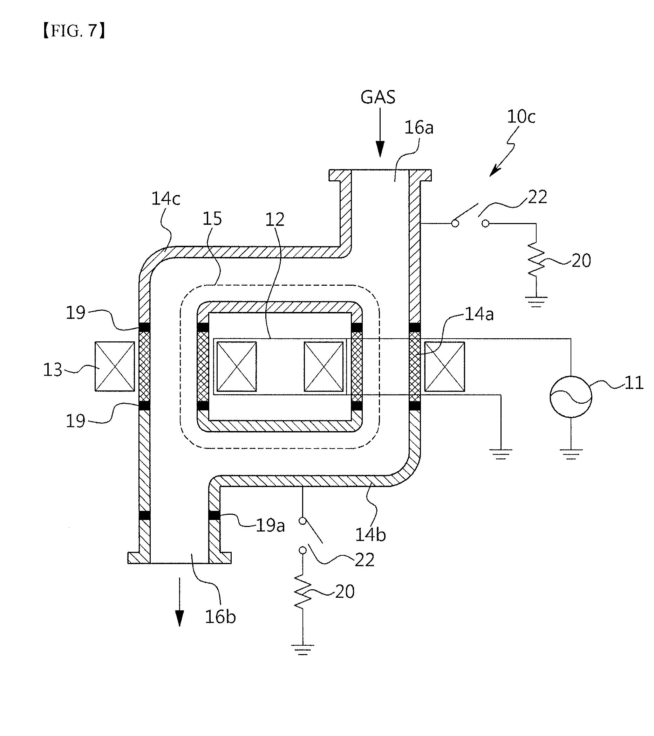

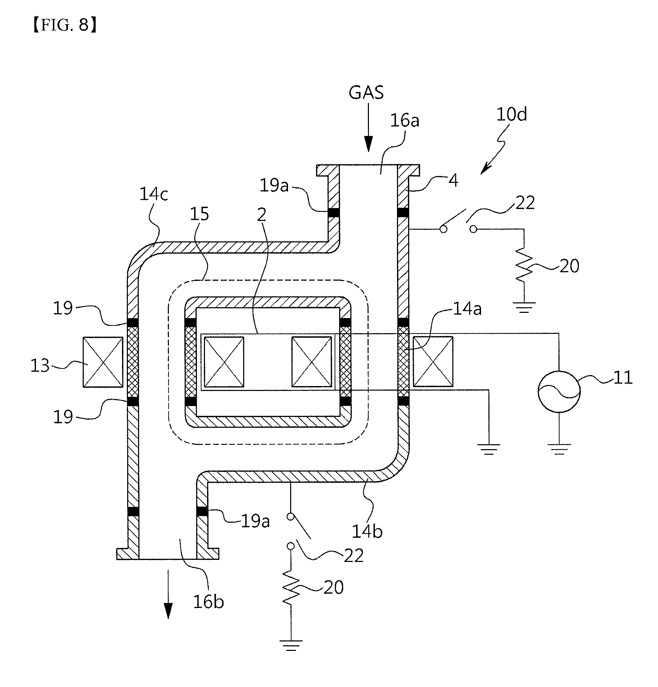

FIG. 6 is a view explaining a TCP/ICP coupled plasma reactor according to a third embodiment of the present invention. FIG. 7 is a view explaining a TCP/ICP coupled plasma reactor according to a fourth embodiment of the present invention. FIG. 8 is a view explaining a TCP/ICP coupled plasma reactor according to a fifth embodiment of the present invention.

Referring to FIG. 6, the plasma reactor, which is designated by reference numeral "10b", has a loop-shaped structure. An insulator 19a is provided at a gas inlet 16a of the plasma reactor 10b. In detail, a plurality of insulating regions 19 is provided such that each insulating region 19 is formed between a plasma chamber body 14a and a corresponding one of first and second floating chambers 14b and 14c. The insulator 19a, which is provided at the gas inlet 16a, functions to insulate the gas inlet 16a.

Referring to FIG. 7, the plasma reactor, which is designated by reference numeral "10c", includes an insulator 19a provided at a gas outlet 16b. In detail, a plurality of insulating regions 19 is provided such that each insulating region 19 is formed between a plasma chamber body 14a and a corresponding one of first and second floating chambers 14b and 14c. The insulator 19a, which is provided at the gas outlet 16b, functions to insulate the gas outlet 16b.

Referring to FIG. 8, the plasma reactor, which is designated by reference numeral "10d", includes insulators 19a respectively provided at a gas inlet 16a and a gas outlet 16b. In detail, a plurality of insulating regions 19 is provided such that each insulating region 19 is formed between a plasma chamber body 14a and a corresponding one of first and second floating chambers 14b and 14c. The insulators 19a, which are provided at the gas inlet 16a and gas outlet 16b, function to insulate the gas inlet 16a and gas outlet 16b, respectively.

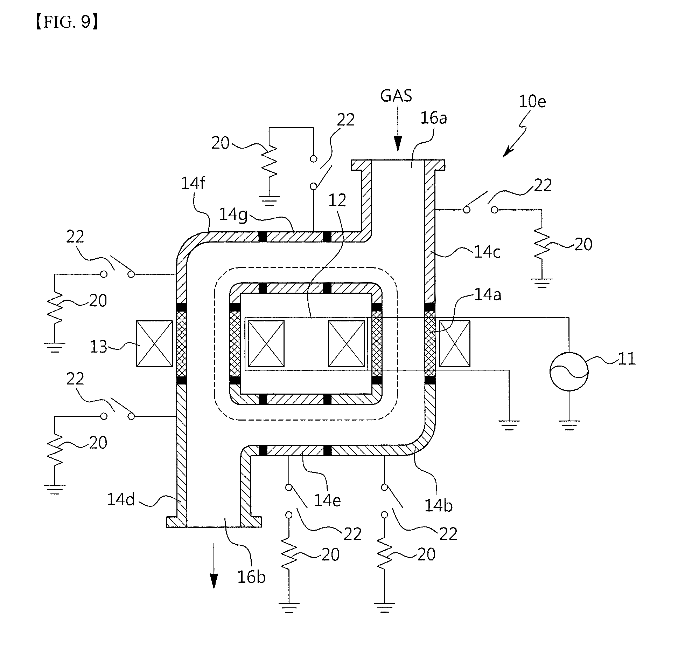

FIG. 9 is a view explaining a TCP/ICP coupled plasma reactor according to a sixth embodiment of the present invention.

Referring to FIG. 9, the plasma reactor, which is designated by reference numeral "10e", includes a plurality of insulating regions 19 symmetrically formed at a reactor body 14, to separate a plasma chamber body 14a and a plurality of floating chambers. The plasma chamber body 14a, at which a magnetic core 13 is installed, is connected to first and second floating chambers 14b and 14c by insulating regions 19 while being connected to third and fifth floating chambers 14d and 14f by insulating regions 19. A sixth floating chamber 14g, which is arranged at a position crossing the plasma chamber body 14a, is connected to the second and fifth floating chambers 14c and 14f by insulating regions 19. A fourth floating chamber 14e is connected to the first and third floating chambers 14b and 14d by insulating regions 19. Thus, the first to sixth floating chambers 14b to 14g are insulated by the insulating regions 19.

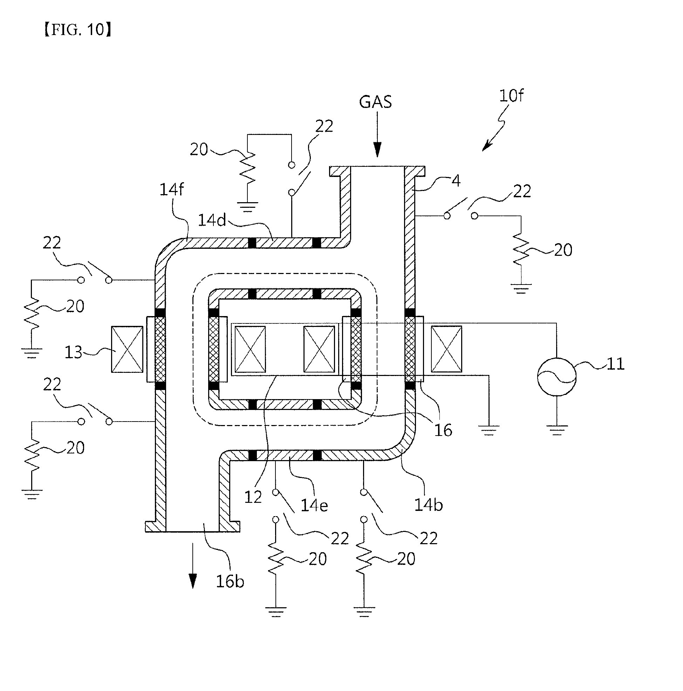

FIG. 10 is a view explaining a TCP/ICP coupled plasma reactor according to a seventh embodiment of the present invention.

Referring to FIG. 10, the plasma reactor, which is designated by reference numeral "10f", includes a plasma chamber body 14a, and first to sixth floating chambers 14b, 14c, 14d, 14e, 14f, and 14g. The plasma chamber body 14a, and first to sixth floating chambers 14b to 14g may be made of a dielectric material. A conductor layer 16 may be formed at each of the plasma chamber body 14a, and first to sixth floating chambers 14b to 14g. In FIG. 10, the conductor layer 16 is illustrated as being formed at a peripheral surface of the plasma chamber body 14a. The plasma reactor including the conductor layer 16 is applicable to the above-described embodiments in the same manner.

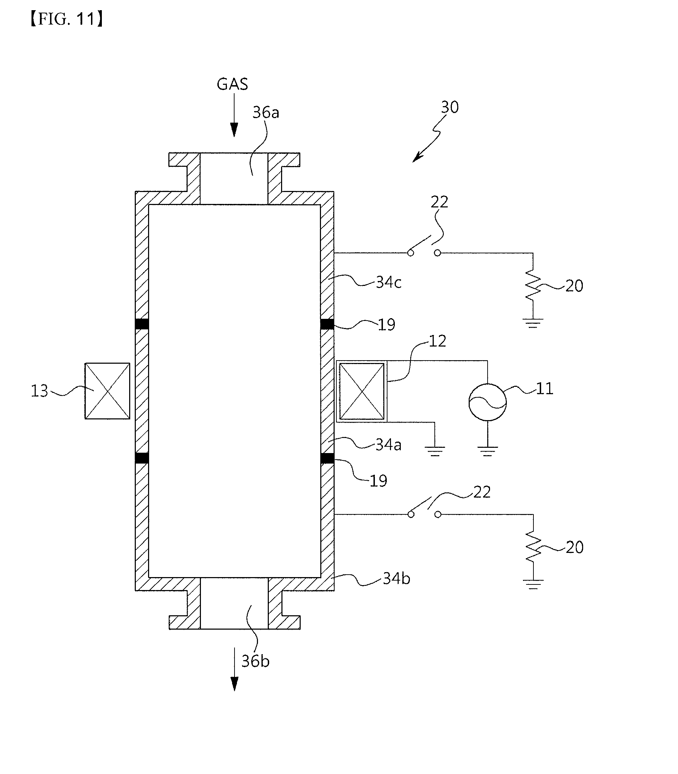

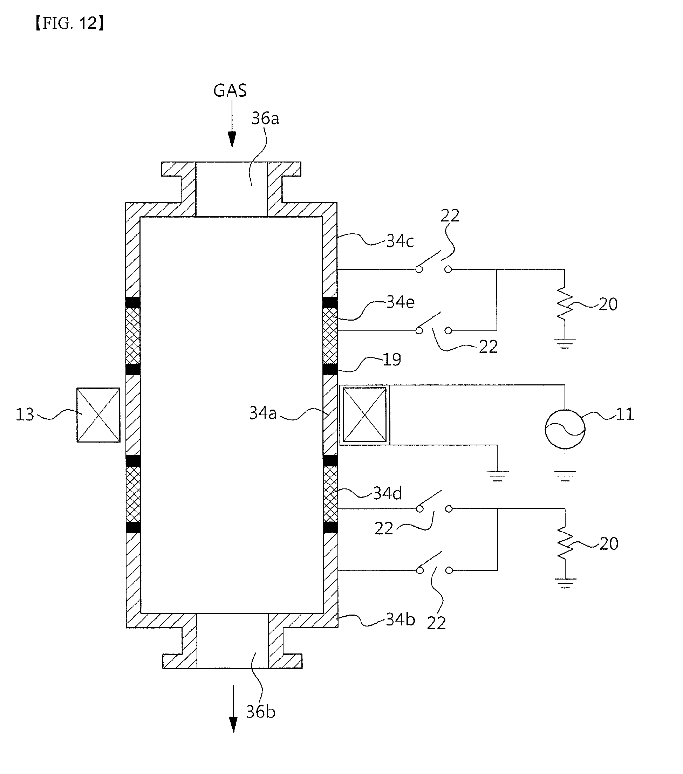

FIG. 11 is a view explaining a TCP/ICP coupled plasma reactor according to an eighth embodiment of the present invention. FIG. 12 is a view explaining a TCP/ICP coupled plasma reactor according to a ninth embodiment of the present invention.

Referring to FIG. 11, the plasma reactor, which is designated by reference numeral "30", includes a plasma chamber body 34a, a gas inlet 36a, a gas outlet 36b, and first and second floating chambers 34b and 34c. The plasma chamber body 34a and first and second floating chambers 34b and 34c have a linear shape. The first and second floating chambers 34b and 34c are insulated from the plasma chamber body 34a by insulating regions 19 at opposite sides of the plasma chamber body 34a. A voltage is directly induced in the plasma chamber body 34a, at which a magnetic core 13 is installed. The voltage is indirectly transferred to the first and second floating chambers 34b and 34c via the insulating regions 19.

Referring to FIG. 12, in the plasma reactor, which is designated by reference numeral "30a", a plasma chamber body 34a and first to fourth floating chambers 34b, 34c, 34d, and 34e are insulated by a plurality of insulating regions 19.

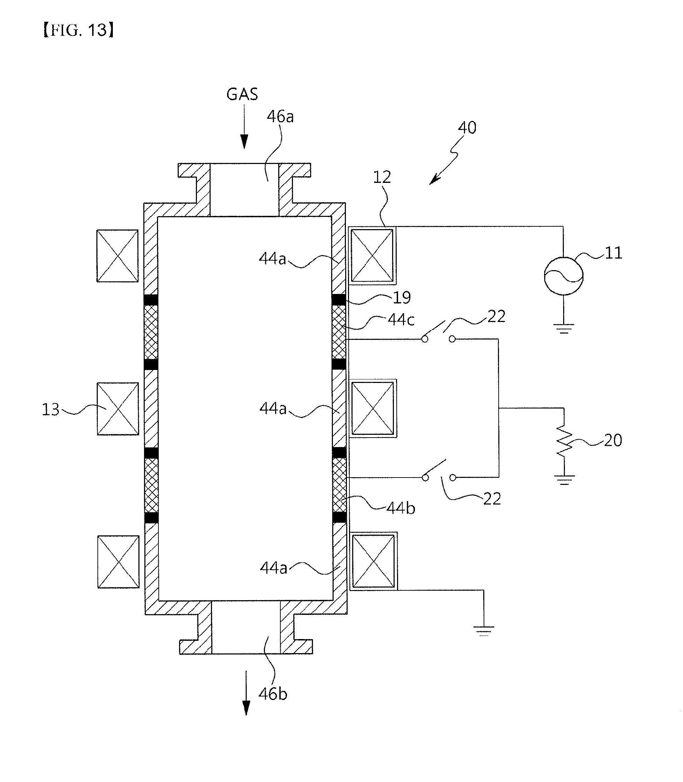

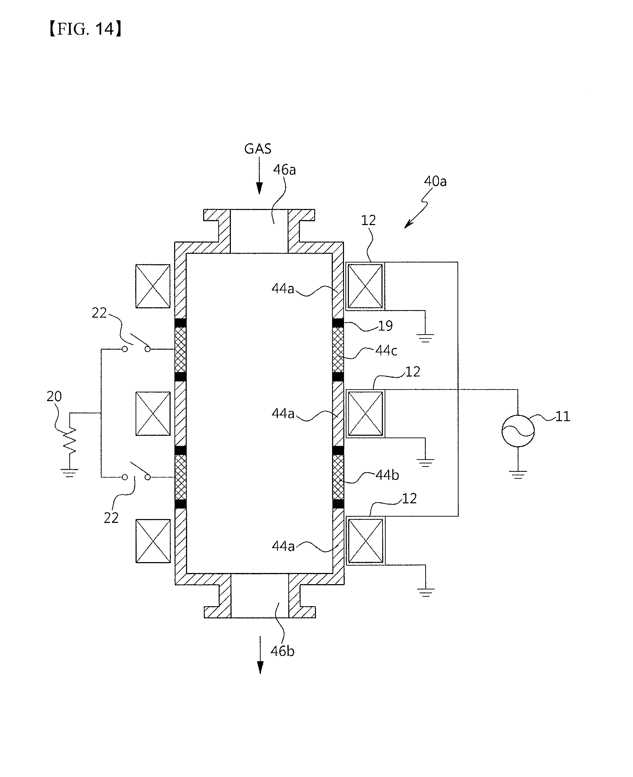

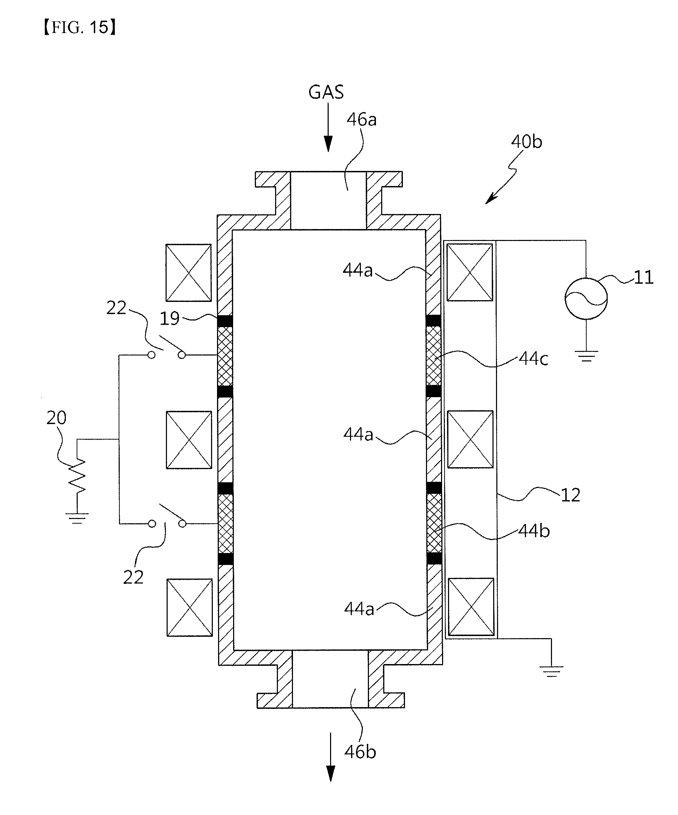

FIG. 13 is a view explaining a TCP/ICP coupled plasma reactor according to a tenth embodiment of the present invention. FIG. 14 is a view explaining a TCP/ICP coupled plasma reactor according to an eleventh embodiment of the present invention. FIG. 15 is a view explaining a TCP/ICP coupled plasma reactor according to a twelfth embodiment of the present invention.

Each of FIGS. 13 to 15 illustrates an arrangement in which primary windings 12 respectively wound on a plurality of magnetic cores 13 installed at a plasma reactor 40, 40a, or 40b are connected in a series manner, a parallel manner, or a series-parallel combined manner.

Referring to FIG. 13, the plasma reactor 40 includes a linear reactor body 44 including a gas inlet 46a and a gas outlet 46b. The plasma reactor 40 has a linear structure, and has a single discharge path established therein. A plurality of magnetic cores 13 is installed at the plasma reactor 40. The plasma reactor 40 includes plasma chamber bodies 44a, at which the magnetic cores 13 are installed, respectively, and a plurality of floating chambers 44b and 44c. The plasma chamber bodies 44a are connected to corresponding ones of the plural floating chambers 44b and 44c by insulating regions 19. The plasma chamber bodies 44a are alternately arranged with the first and second floating chambers 44b and 44c, to form the plasma reactor 40. In this case, primary windings 12 are wound on respective magnetic cores 13. The primary windings 12 are connected to receive AC power from a single AC power supply 11.

Referring to FIG. 14, the plasma reactor 40a has the same configuration as the plasma reactor 40 of FIG. 13. In this case, however, the primary windings 12 wound on respective magnetic cores 13 may receive AC power from different AC power supplies 11, respectively. The different AC power supplies 11 may supply AC power having the same frequency or AC power having different frequencies.

Referring to FIG. 15, the plasma reactor 40b has the same configuration as the plasma reactor 40 of FIG. 13. In this case, however, a single primary winding 12 is wound on the plural magnetic cores 13 and, as such, may receive AC power from a single AC power supply 11. In addition, the primary winding 12 may be wound on the plural magnetic cores 13 in various manners other than the above-described manners.

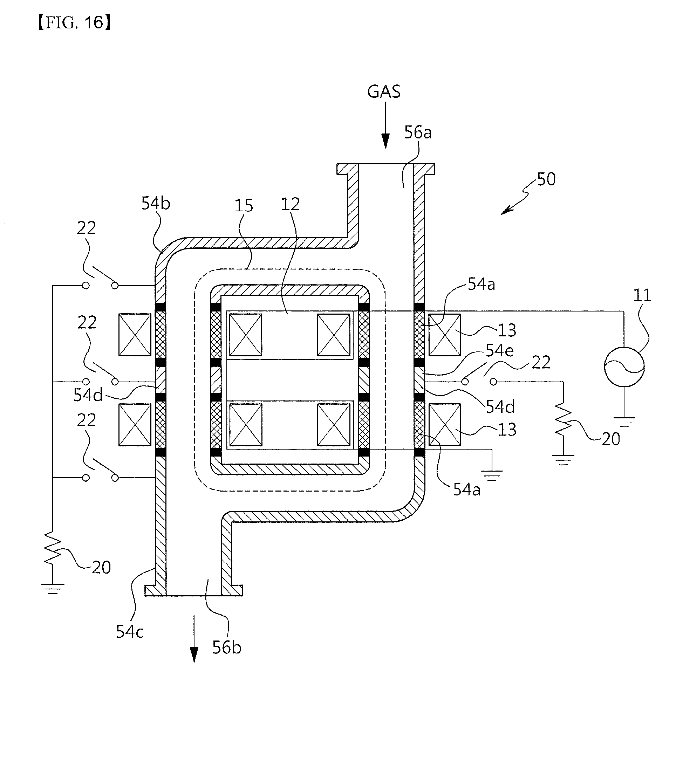

FIG. 16 is a view explaining a TCP/ICP coupled plasma reactor according to a thirteenth embodiment of the present invention.

Referring to FIG. 16, the plasma reactor, which is designated by reference numeral "50", includes a quadrangular reactor body 54 including a gas inlet 56a and a gas outlet 56b while having a loop-shaped discharge path established therein. A plurality of magnetic cores 13 is installed at the plasma reactor 50. The plural magnetic cores 13 are arranged at facing portions of the loop-shaped discharge path, respectively. The magnetic cores 13 are installed at plasma chamber bodies 54a, respectively, and, as such, each plasma chamber body 54a is a region, to which induced electromotive force is directly induced. First to fourth floating chambers 54b, 54c, 54d, and 54e are arranged to alternate with the plasma chamber bodies 54a. The first to fourth floating chambers 54b, 54c, 54d, and 54e are connected to corresponding ones of the plasma chamber bodies 54a by insulating regions 19 and, as such, each floating chamber 54b, 54c, 54d, or 54e is a region, to which induced electromotive force from the corresponding plasma chamber body 54a is indirectly induced.

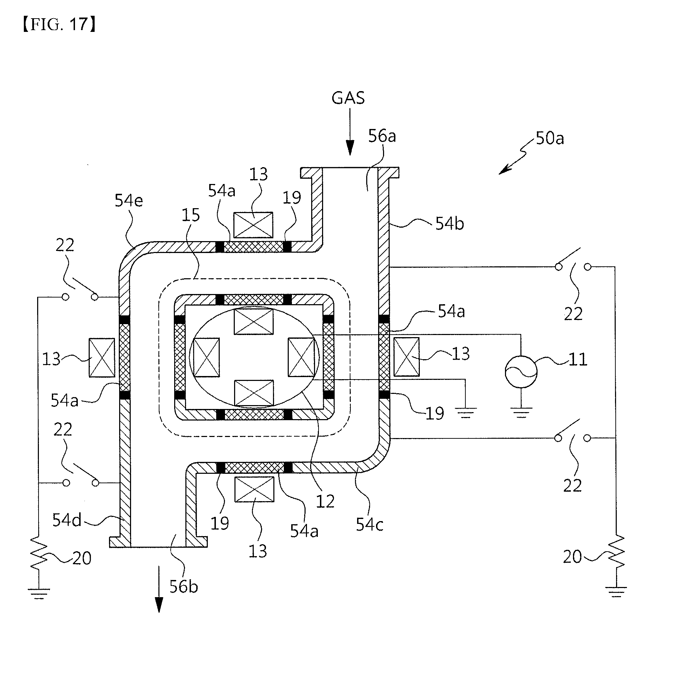

FIG. 17 is a view explaining a TCP/ICP coupled plasma reactor according to a fourteenth embodiment of the present invention.

Referring to FIG. 17, the plasma reactor, which is designated by reference numeral "50a", has the same configuration as the plasma reactor 50 illustrated in FIG. 16. That is, the plasma reactor 50a includes a quadrangular reactor body 54 having a loop-shaped discharge path established therein. However, the plural magnetic cores 13 are arranged at symmetrical positions in the loop-shaped discharge path, respectively. For example, four magnetic cores 13 may be symmetrically installed at plasma chamber bodies 54a forming respective sides of the quadrangular plasma reactor body 54. At least one magnetic core 13 may be installed at each side of the plasma reactor body 54. The plasma chamber bodies 54a, at which respective magnetic cores 13 are installed, are connected to corresponding ones of first to fourth floating chambers 54b, 54c, 54d, and 54e by insulating regions 19.

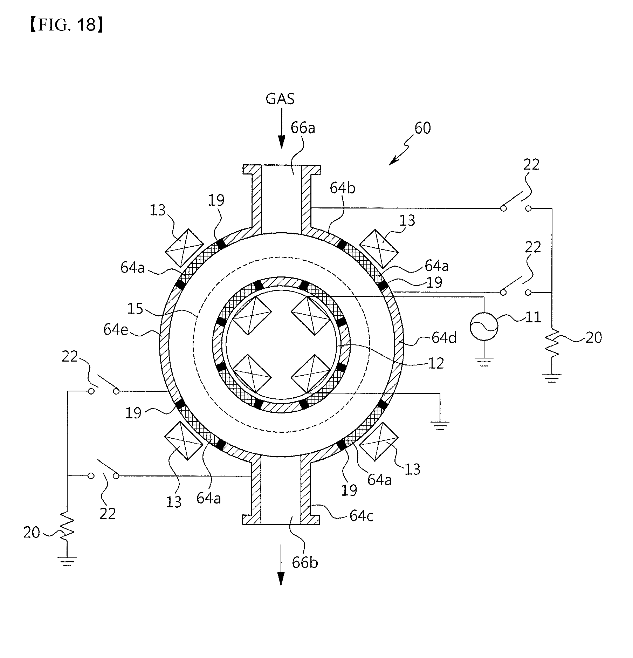

FIG. 18 is a view explaining a TCP/ICP coupled plasma reactor according to a fifteenth embodiment of the present invention.

Referring to FIG. 18, the plasma reactor, which is designated by reference numeral "60", includes a circular reactor body 64 including a gas inlet 66a and a gas outlet 66b while having a loop-shaped discharge path established therein. A plurality of magnetic cores 13 is arranged along the circular plasma reactor body 64. The magnetic cores 13 are installed at plasma chamber bodies 64a, respectively, while being connected to corresponding ones of first to fourth floating chambers 64b, 64c, 64d, and 64e by insulating regions 19.

The shapes of the reactor bodies 54 and 64 illustrated in FIGS. 17 and 18 are illustrative and, as such, the present invention is applicable to plasma reactors having various shapes, in which a loop-shaped discharge path is established.

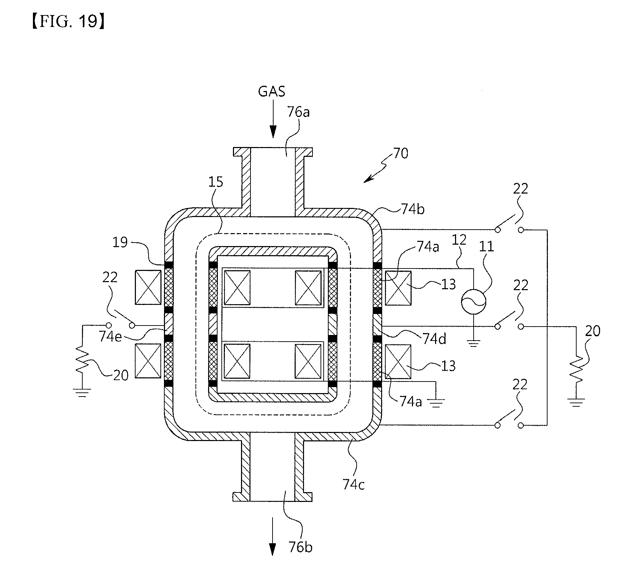

FIG. 19 is a view explaining a TCP/ICP coupled plasma reactor according to a sixteenth embodiment of the present invention.

Referring to FIG. 19, the plasma reactor, which is designated by reference numeral "70", has a structure in which a gas inlet 76a and a gas outlet 76b are aligned with each other while being disposed centrally of first and second floating chambers 74b and 74c. The first and second floating chambers 74b and 74c are connected to plasma chamber bodies 74a by insulating regions 19, respectively. In this case, a plurality of magnetic cores 13 may be installed at the plasma reactor 70 such that they face each other or are symmetrically positioned in a discharge path, as illustrated in FIG. 16 or 17.

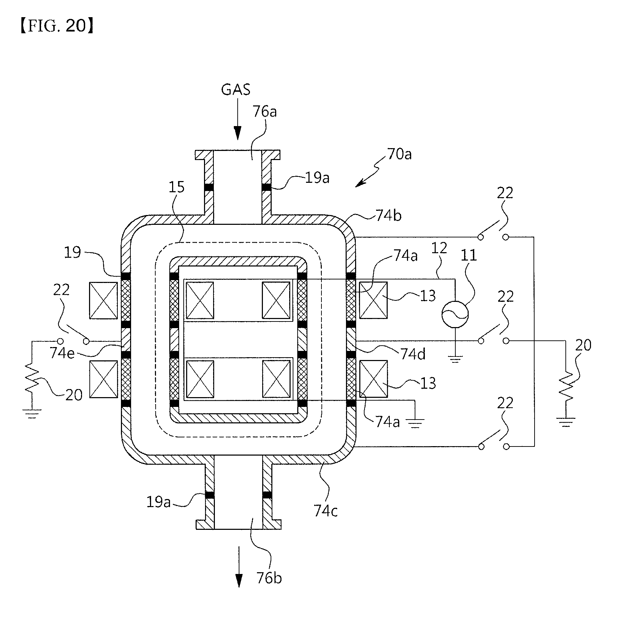

FIG. 20 is a view explaining a TCP/ICP coupled plasma reactor according to a seventeenth embodiment of the present invention.

Referring to FIG. 20, the plasma reactor, which is designated by reference numeral "70a", has the same configuration as the plasma reactor 70 illustrated in FIG. 19. However, the plasma reactor 70a further includes insulators 19a respectively provided at the gas inlet 76a and gas outlet 76b. The insulators 19a electrically insulate the gas inlet 16a and gas outlet 16b, respectively. Although not shown, such an insulator 19a may be installed only at the gas inlet 76a or at the gas outlet 76b.

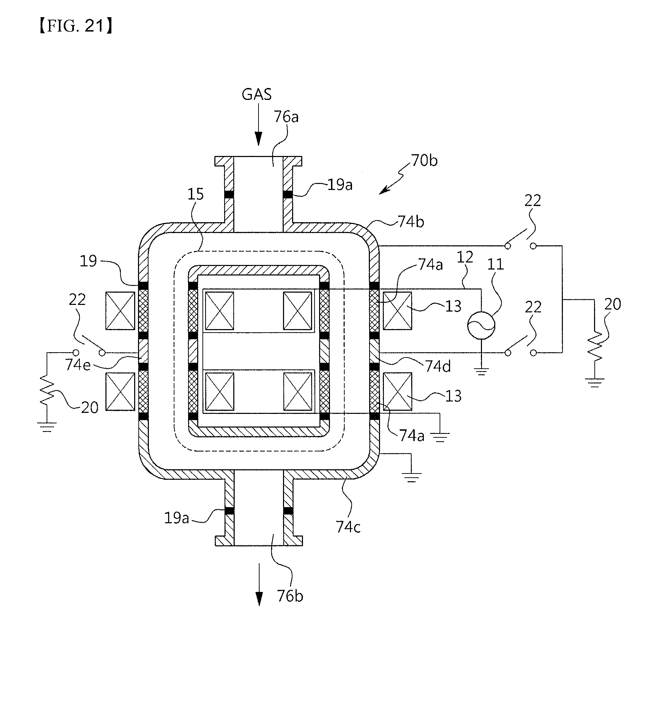

FIG. 21 is a view explaining a TCP/ICP coupled plasma reactor according to an eighteenth embodiment of the present invention.

Referring to FIG. 21, the plasma reactor, which is designated by reference numeral "70b", has the same configuration as the plasma reactor 70 illustrated in FIG. 19. However, the second floating chamber 74c, which is provided with the gas outlet 76b, is connected to the ground. Accordingly, the first floating chamber 74b, which is provided with the gas inlet 76a, and the third and fourth floating chambers 74d and 74e are connected to the high resistor 20 via switching circuits 22 after a plasma process. Although not shown, any one of the plural floating chambers may be connected to the ground.

As is apparent from the above description, the plasma reactor according to the present invention and the plasma ignition method using the same have the following effects.

First, it is possible to achieve plasma discharge even when a relatively low voltage is supplied, as compared to conventional cases, thereby enabling supply of an inexpensive product while minimizing damage to the plasma reactor caused by arc discharge, and a plasma ignition method using the plasma reactor.

Second, it is possible to easily achieving ignition for plasma discharge, as compared to conventional cases, even when the same voltage as that of conventional cases is supplied at a low gas flow rate and a low gas pressure.

Third, it is possible to easily achieve ignition for plasma discharge, as compared to conventional cases, even when the same voltage as that of conventional cases is supplied at a low temperature.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A plasma reactor comprising:
at least one magnetic core having a transformer primary winding wound thereon;
an AC power supply for supplying AC power to the transformer primary winding wound on the magnetic core;
at least one plasma chamber body, at which the magnetic core is installed, to directly induce a voltage in the plasma chamber body through the magnetic core, thereby inducing induced electromotive force in the plasma chamber body; and
at least one floating chamber connected to the plasma chamber body via an insulating region, the induced electromotive force from the plasma chamber body being indirectly transferred to the floating chamber,
wherein ignition of plasma is generated in accordance with a voltage difference generated between the plasma chamber body and the floating chamber, and the ignited plasma is supplied to a process chamber.

2. The plasma reactor according to claim 1, wherein the plasma chamber body and the floating chamber have a linear shape, to establish a discharge path therein.

3. The plasma reactor according to claim 2, wherein the at least one magnetic core comprises a plurality of magnetic cores, and the at least one plasma chamber body comprises a plurality of plasma chamber bodies, at which the plural magnetic cores are installed, respectively.

4. The plasma reactor according to claim 1, wherein the plasma chamber body and the floating chamber have a loop shape, to establish a loop-shaped discharge path therein.

5. The plasma reactor according to claim 4, wherein the at least one magnetic core comprises at least four magnetic cores, and the at least one plasma chamber body comprises a plurality of plasma chamber bodies, at which the magnetic cores are installed such that at least one of the magnetic cores is installed at each of the plasma chamber bodies, to form a symmetrical structure in the loop-shaped discharge path.

6. The plasma reactor according to claim 1, wherein the plasma chamber body and the floating chamber are made of the same material.

7. The plasma reactor according to claim 6, wherein the material is aluminum.

8. The plasma reactor according to claim 6, wherein the material is one of a conductor material and a dielectric material.

9. The plasma reactor according to claim 8, wherein the dielectric material is ceramic.

10. The plasma reactor according to claim 8, wherein the plasma chamber body and the floating chamber are made of a dielectric material, and a conductor layer is formed on a peripheral surface of the plasma chamber body or a peripheral surface of the floating chamber.

11. The plasma reactor according to claim 1, wherein the insulating region is made of a dielectric material, and comprises a rubber for vacuum insulation.

12. The plasma reactor according to claim 11, wherein the dielectric material is ceramic.

13. The plasma reactor according to claim 1, wherein the insulating region has a width determined in accordance with an intensity of a voltage of the AC power supplied from the AC power supply.

14. The plasma reactor according to claim 1, wherein the floating chamber comprises:
a resistor for discharging charges charged after a plasma process to supply the plasma to the process chamber; and
a switching circuit for connecting the resistor and the floating chamber after the plasma process.

15. A plasma reactor comprising:
at least one magnetic core having a transformer primary winding wound thereon;
an AC power supply for supplying AC power to the transformer primary winding wound on the magnetic core;
at least one plasma chamber body, at which the magnetic core is installed, to directly induce a voltage in the plasma chamber body through the magnetic core, thereby inducing induced electromotive force in the plasma chamber body; and
a plurality of floating chambers connected to the plasma chamber body via insulating regions, the induced electromotive force from the plasma chamber body being indirectly transferred to the floating chambers,
wherein the plural floating chambers are connected to one another by insulating regions, and ignition of plasma is generated in accordance with a voltage difference generated between the plasma chamber body and the floating chambers, and the ignited plasma is supplied to a process chamber.

16. The plasma reactor according to claim 15, wherein the plasma chamber body and the floating chambers have a linear shape, to establish a discharge path therein.

17. The plasma reactor according to claim 16, wherein the at least one magnetic core comprises a plurality of magnetic cores, and the at least one plasma chamber body comprises a plurality of plasma chamber bodies, at which the plural magnetic cores are installed, respectively.

18. The plasma reactor according to claim 15, wherein the plasma chamber body and the floating chambers have a loop shape, to establish a loop-shaped discharge path therein.

19. The plasma reactor according to claim 18, wherein the at least one magnetic core comprises at least four magnetic cores, and the at least one plasma chamber body comprises a plurality of plasma chamber bodies, at which the magnetic cores are installed such that at least one of the magnetic cores is installed at each of the plasma chamber bodies, to form a symmetrical structure in the loop-shaped discharge path.

20. The plasma reactor according to claim 15, wherein the plasma chamber body and the floating chambers are made of the same material.

21. The plasma reactor according to claim 20, wherein the material is aluminum.

22. The plasma reactor according to claim 20, wherein the material is one of a conductor material and a dielectric material.

23. The plasma reactor according to claim 22, wherein the dielectric material is ceramic.

24. The plasma reactor according to claim 22, wherein the plasma chamber body and the floating chambers are made of a dielectric material, and a conductor layer is formed on a peripheral surface of the plasma chamber body or peripheral surfaces of the floating chambers.

25. The plasma reactor according to claim 15, wherein the insulating region is made of a dielectric material, and comprises a rubber for vacuum insulation.

26. The plasma reactor according to claim 25, wherein the dielectric material is ceramic.

27. The plasma reactor according to claim 15, wherein the insulating region has a width determined in accordance with an intensity of a voltage of the AC power supplied from the AC power supply.

28. The plasma reactor according to claim 15, wherein each of the floating chambers comprises:
a resistor for discharging charges charged after a plasma process to supply the plasma to the process chamber; and
a switching circuit for connecting the resistor and the floating chamber after the plasma process.

29. The plasma reactor according to claim 15, wherein additional insulating regions are formed at a gas inlet and a gas outlet, respectively.

30. The plasma reactor according to claim 15, wherein each of the additional insulating regions is formed at a position crossing the plasma chamber body, at which the magnetic core is installed.

31. The plasma reactor according to claim 15, wherein an additional insulating region is formed at a gas inlet.

32. The plasma reactor according to claim 15, wherein an additional insulating region is formed at a gas outlet.

33. The plasma reactor according to claim 15, wherein one of the plural floating chambers is connected to a ground.

34. The plasma reactor according to claim 33, wherein one of the floating chambers, which is provided with a gas inlet, is in a floated state, and another one of the floating chambers, which is provided with a gas outlet, is connected to the ground.

35. A plasma ignition method comprising:
supplying a gas through a gas inlet while supplying AC power from a AC power supply to a primary winding wound on a magnetic core;
directly inducing induced electromotive force in a plasma chamber body, at which the magnetic core is installed;
transferring the induced electromotive force induced in the plasma chamber body to a plurality of floating chambers, thereby inducing discharge of plasma in a reactor body;
supplying the discharged plasma to a process chamber through a gas outlet; and
connecting each of the floating chambers to a high resistor, for discharge of charges charged in the floating chamber after the induction of plasma discharge.

36. The plasma ignition method according to claim 35, wherein the connecting the floating chamber to the high resistor comprises connecting the floating chamber to the high resistor via a switching circuit.
